# FASCICULE DE BREVET EUROPEEN

(11) **EP 1 838 404 B1**
(45) Date de publication et mention de la délivrance du brevet: **17.08.2016**
(21) Numéro de dépôt: 05824678.6
(22) Date de dépôt: 07.12.2005
(51) Int. Cl.: B01J 8/02, B01D 3/20, B01D 3/32, B01J 8/00

(54) **PLATEAU INTERNE POUR ENCEINTE**
INNENSCHALE FÜR EINE KAMMER
INNER TRAY FOR A CHAMBER

(30) Priorité: 08.12.2004 FR 0413065
(43) Date de publication de la demande: 03.10.2007
(73) Titulaire: Total Raffinage France, 92400 Courbevoie (FR)
(72) Inventeur: NASCIMENTO, Pedro, F-76600 Le Havre (FR); DA SILVA, Pedro, F-69700 Chassagny (FR); ALLEN, Matthew, 14600 Pennedepie (FR)
(74) Mandataire: Radault, Gabrielle
(86) Numéro de dépôt international: PCT/FR2005/003070
(87) Numéro de publication internationale: WO 2006/061516

(56) Documents cités:
- DE-A1- 1 920 268
- GB-A- 625 418
- GB-A- 2 321 417
- US-A- 6 068 244

## Description

L'invention concerne un nouveau type d'interne destiné à être installé à l'intérieur d'une enceinte, notamment cylindrique, pouvant être monté et démonté rapidement, sans soudure, sans vis ni boulons de fixation.

L'invention concerne plus particulièrement un plateau distributeur pour réacteur chimique à lit catalytique fixe, alimenté par un mélange gaz/liquide et fonctionnant, de préférence, à co-courant descendant.

C'est à cette application que l'on se référera dans la suite de la présente description, mais l'interne selon l'invention peut être installé dans toutes sortes d'enceintes de taille importante, utilisées dans l'industrie chimique ou pétrolière ou ailleurs, dans lesquelles il est nécessaire d'installer par exemple, une plate-forme de séparation ou un plateau, perforé ou non, pouvant servir par exemple à la distribution d'un liquide ou encore de plateau-support pour tout type de charge ou de garnissage.

Dans les réacteurs chimiques à lit catalytique fixe, traversés par un courant descendant mixte constitué d'une phase gazeuse et d'une phase liquide, la dispersion fine de cette dernière phase dans la phase gazeuse et la répartition régulière du mélange obtenu sur l'ensemble de la surface du lit catalytique constituant la zone réactionnelle, se font couramment au moyen de plateaux perforés sensiblement horizontaux appelés « plateaux distributeurs ». A cet effet, ces plateaux sont généralement formés par une seule plaque ou par un ensemble de plaques juxtaposées, soudées, vissées ou boulonnées, d'une surface totale sensiblement identique à la surface de la section transversale du réacteur, généralement cylindrique. Chaque plaque comporte un grand nombre de perforations entourées chacune d'une paroi cylindrique verticale (appelée « cheminée » dans la technique) comprenant, à sa base, un ou plusieurs trous ou fentes. Ces plateaux distributeurs munis de cheminées fonctionnent selon le principe suivant : le gaz introduit sous pression par le haut du réacteur passe par les perforations entourées par les cheminées. Le liquide, également introduit par le haut de l'enceinte, est retenu sur la plaque d'où il ne peut s'écouler librement en raison de l'effet de barrage des cheminées. Le liquide monte à un niveau identique à celui de la hauteur des trous à la base des cheminées et s'écoule à travers ceux-ci dans la lumière des cheminées où il est dispersé en fines gouttelettes en étant emporté par le flux gazeux.

Des calottes, ou des clapets circulaires ou en forme de linguets, peuvent remplacer les cheminées ci-dessus indiquées, notamment dans les plateaux utilisés comme éléments augmentant la surface de contact entre le gaz et le liquide dans les colonnes de distillation, par exemple les colonnes de distillation du pétrole brut. On trouve également dans la technique des plateaux perforés à déversoir, dans lesquels le passage du gaz est assuré par de simples perforations réparties dans les plaques formant l'aire active des dits plateaux.

La présente invention concerne non pas les différents types d'éléments de retenue, de mélange ou de dispersion de la phase liquide, mais un système d'assemblage et de fixation de plaques constituant le plateau à l'intérieur du réacteur. Ce système d'assemblage et de fixation, tel que décrit ci-dessous, n'est par conséquent pas limité à un type particulier de plaques ou d'utilisation, mais s'applique à tout type de plateaux devant être installés et, si besoin, démontés rapidement dans tout type d'enceintes.

Différents plateaux distributeurs pour réacteurs chimiques ont été proposés dans la technique et décrits par exemple, dans FR 2 745 202, EP 768 914, EP 1 147 809, US 3 524 731 ou encore US 5 882 610. Certains de ces plateaux sont du type monoplaque, à structure autoporteuse, et sont montés d'origine à l'intérieur du réacteur. D'autres sont constitués de plusieurs éléments fixés les aux autres, ainsi que sur des poutres de maintien, par des vis ou des boulons, comme indiqués dans US 5 192 465 ou US 6 267 359. Le document GB 2 321 417 décrit un plateau composé de plusieurs éléments vissés entre eux et supporté notamment par une poutre et un support annulaire solidaires de l'enceinte. L'assemblage du plateau à la poutre ou au support annulaire n'est pas détaillé. Le document GB 625 418 décrit un plateau composé de plusieurs éléments vissés entre eux et vissés à un support annulaire solidaire de la paroi de l'enceinte. Un tel système de vissage ou de boulonnage présente plusieurs inconvénients, et notamment celui du coût important d'approvisionnement en vis ou boulons, en particulier quand la surface du plateau distributeur peut atteindre plus d'une dizaine de m². Un autre inconvénient lié à ce système de fixation est de rendre long et difficile le montage et surtout le démontage, total ou partiel, de celui-ci à l'intérieur du réacteur, par exemple en cas de renouvellement du lit catalytique. De plus, le personnel chargé de ces opérations doit être protégé contre les éventuelles vapeurs toxiques résiduelles par des combinaisons de protection qui limitent fortement leur mobilité et leur agilité quant à la manipulation d'outils tels que des clés ou tournevis. Tous ces inconvénients liés à des manipulations longues et difficiles impliquant, in fine, un temps d'immobilisation prolongé du réacteur, préjudiciable à la rentabilité de l'exploitation.

Le document DE 19 20 268 décrit un plateau composé de plusieurs éléments dont certains sont assemblés entre eux par emboîtement. Le document US 6 068 244 décrit un plateau composé de plusieurs éléments assemblés entre eux par emboîtement.

De plus, pour garantir un fonctionnement sans perturbation ainsi qu'une répartition régulière du mélange gaz/liquide à la surface du lit catalytique, un plateau distributeur doit être plan et horizontal et le plus étanche possible au niveau des jonctions entre les différents éléments le constituant.

La Demanderesse, dans le cadre de ses recherches visant à améliorer la structure des plateaux distributeurs et à en faciliter l'installation dans les réacteurs, a mis au point un nouveau type de plateau à la fois solide, étanche au niveau des jonctions entre les plaques le constituant, et facile à monter ou démonter. Ce plateau est constitué d'un ensemble de plaques dont certains bords sont conformés en parties femelles ou mâles, capables de s'emboîter respectivement dans les parties mâles ou femelles complémentaires des plaques adjacentes, de manière à former des rangées de plaques juxtaposées fixées les unes aux autres sans utilisation de vis ni de boulons. Dans le réacteur, ces rangées de plaques, qui doivent être perforées pour ce type précis d'utilisation, sont supportées par des poutres fixées par leurs extrémités aux parois du réacteur auxquelles elles sont rendues solidaires par un système sans vis ni boulons.

Le système d'assemblage et de fixation de plaques selon la présente invention permet ainsi un démontage, partiel ou total, et un remontage très rapide du plateau distributeur, un dimensionnement, à la demande, de la taille du trou d'homme, ainsi qu'une parfaite étanchéité au niveau des jonctions entre plaques adjacentes. De plus, bien que les plaques soient disposées sur les poutres par l'intermédiaire de deux bords parallèles seulement, leur fixation sur celles-ci conformément à l'invention, ainsi que le système proposé d'emboîtement des plaques entre elles, permet leur positionnement rigide, résistant au déplacement non souhaité que pourraient provoquer divers changements brutaux de pression (coups de béliers) susceptibles de se produire au cours du fonctionnement du réacteur.

La présente invention a par conséquent pour objet un interne, également appelé par la suite « plateau interne », disposé dans une enceinte, comprenant une pluralité de poutres parallèles, situées dans un même plan horizontal et fixées par leurs extrémités à la paroi de l'enceinte, et, entre ces poutres et supportées par celles-ci, des rangées de plaques rectangulaires jointives, couvrant complètement l'espace entre les poutres, caractérisé par le fait
que les bords d'appui des plaques par lesquels celles-ci reposent sur les poutres, sont pliés vers le bas par deux plis sensiblement à angle droit, et
que chacun des bords des plaques, perpendiculaires aux poutres, est plié de manière à former une partie femelle ou une partie mâle capable de s'emboîter respectivement dans une partie mâle ou femelle formée par le bord plié de la plaque adjacente.

Chacune des plaques rectangulaires formant le plateau interne de la présente invention a par conséquent deux bords d'assemblage et deux bords d'appui par lesquels elle repose sur les poutres de support.

Par ailleurs, chacune des plaques rectangulaires du plateau selon l'invention comporte de préférence une pluralité de perforations, de préférence entourées chacune d'une paroi cylindrique verticale (cheminée) comprenant, à sa base, un ou plusieurs trous ou fentes.

Les poutres supportant les plaques ont de préférence une section transversale comportant une partie en forme de T renversé, avec une partie verticale et deux parties horizontales destinées à supporter les bords d'appui des plaques rectangulaires formant le plateau selon l'invention.

Les bords d'assemblage peuvent être de type mâle (= bord formant une partie mâle) ou de type femelle (= bord formant une partie femelle) et chaque plaque peut comporter deux bords mâles ou deux bords femelles ou encore un bord mâle et un bord femelle, ces deux bords d'assemblage étant parallèles l'un à l'autre et perpendiculaires aux poutres de support.

Dans un mode de réalisation préféré de la présente invention, on forme une partie mâle au niveau des bords des plaques grâce à un simple pli dudit bord vers le bas, de préférence un simple pli à angle droit vers le bas. Ce bord mâle, de structure simple et très facile à fabriquer, s'emboîte dans un bord complémentaire de type femelle, formé de préférence grâce à un pli vers le bas suivi d'un pli vers le haut, aboutissant à une conformation en V ou en U. Pour assurer une bonne étanchéité au niveau des joints d'assemblage des plaques, la largeur de la partie repliée des bords mâles est sensiblement identique à la profondeur de la structure en V ou en U du bord femelle.

L'assemblage d'une rangée de plaques perforées rectangulaires peut ainsi se faire à l'intérieur de l'enceinte par simple insertion des bords mâles dans les bords femelles.

Chaque plaque rectangulaire comporte ainsi deux bords d'assemblage, mâles ou femelles, et deux bords par lesquels la rangée de plaques repose sur les poutres de support. Dans un mode de réalisation préféré de la présente invention, les parties pliées des bords sont soudées les unes aux autres au niveau des coins des plaques perforées, ce qui augmente avantageusement la rigidité de la plaque.

Pour assurer une bonne étanchéité du plateau au niveau des joints d'assemblage, des joints d'étanchéité sont de préférence prévus au niveau des surfaces de contact entre la partie femelle d'une plaque et la partie mâle d'une plaque adjacente. Ces joints d'étanchéité doivent avoir une bonne résistance thermique et une bonne résistance chimique vis-à-vis du milieu réactionnel qui peut être, par exemple, un solvant hydrocarboné. On peut citer à titre de matériaux d'étanchéité préférés pour l'application dans des réacteurs d'hydrocarbures, les fibres céramiques ou les fibres de carbone. Ces fibres sont de préférence sous forme de textile tissé, tricoté ou non-tissé. La forme textile permet une application particulièrement facile, souple et régulière sur toute la longueurs des bords d'assemblage.

Des textiles en fibres céramiques ou en fibres de carbone utilisables en tant que joints d'étanchéité pour les plateaux distributeurs de la présente invention sont connus et sont disponibles respectivement par exemple auprès des sociétés Silitex sous la référence VRT750 et Bekaert sous la référence Bekitherm NP350.

Pour les raisons précédemment indiquées, des joints d'étanchéité du type ci-dessus sont de préférence également prévus au niveau des surfaces de contact entre les poutres de support et les parties pliées des bords reposant sur celles-ci. Dans un mode de réalisation particulièrement préféré de la présente invention, les faces supérieures des deux branches horizontales des poutres de support sont recouvertes, sur toute leur largeur et toute leur longueur, d'une structure textile en fibres céramiques ou fibres de carbone. Cette structure textile peut également s'étendre sur une partie ou la totalité de la surface de la partie verticale des poutres, en particulier celle en contact avec les bords des plaques perforées.

La partie verticale des poutres supportant les rangées de plaques de la présente invention ne sert pas uniquement de butée pour l'alignement des plaques de chaque rangée mais peut également servir à immobiliser et à fixer les plaques sur les poutres sans utilisation de vis ni de boulons. Pour permettre une telle fixation sans vis ni boulons des plaques, la partie verticale des poutres doit faire saillie au-delà du plan horizontal défini par celles-ci, au moins sur une partie de la longueur des poutres.

Dans leur partie(s) verticale(s) faisant saillie au-delà du plan horizontal défini par les plaques jointives, les poutres de support comportent des orifices, ou guides, permettant d'insérer des moyens de fixation, autres que des vis ou des boulons, pour immobiliser les plaques sur les parties horizontales des poutres. Ces moyens de fixation sont par exemple des goupilles ou des clavettes. Un mode de réalisation particulièrement préféré d'un système de fixation est décrit plus en détail ci-après en référence aux dessins annexés.

En principe, les plaques perforées formant un plateau de distribution selon la présente invention peuvent être en n'importe quel matériau suffisamment rigide pour ne pas subir une déformation plastique sous une charge équivalente à celle d'un homme. Le matériau doit en outre avoir une bonne résistance chimique au milieu réactionnel. Enfin, le matériau doit avantageusement être déformable à chaud ou à froid de manière à permettre le pliage des bords des plaques. Dans un mode de réalisation préféré de l'invention, les plaques perforées sont fabriquées en acier inoxydable, et notamment en acier dénommé commercialement SS 321.

L'épaisseur des plaques dépend, bien entendu, des propriétés mécaniques du matériau les constituant et de la taille des plaques. Cette épaisseur doit être suffisante pour conférer aux plaques une bonne résistance à la déformation mais ne doit pas dépasser une certaine limite supérieure au-delà de laquelle le pliage des bords serait trop difficile et au-delà de laquelle les plaques auraient un poids trop important pour être soulevées par un être humain. La Demanderesse a constaté qu'une épaisseur comprise entre 1 mm et 10 mm, et de préférence entre 3 mm et 5 mm, permettait généralement de fabriquer des plaques présentant à la fois une bonne résistance à la déformation et une bonne aptitude au pliage.

L'épaisseur des plaques de la présente invention peut être inférieure à celle de plaques équivalentes connues, non pliées sur leurs bords. En effet, la présence de quatre bords pliés, éventuellement soudés les uns aux autres au niveau des coins, augmente considérablement la rigidité des plaques.

Les plaques perforées rectangulaires décrites ci-dessus sont assemblées en rangées, après introduction dans le réacteur. Cet assemblage se fait de préférence en partant du ou des bords du plateau de distribution, c'est-à-dire à partir des parois du réacteur. Lorsque le réacteur a une forme cylindrique, ce qui est généralement le cas, les plaques perforées adjacentes à la paroi ne sont, bien entendu, pas rectangulaires, mais comportent un bord incurvé. Ce bord incurvé repose sur un anneau de support fixé à la paroi du réacteur. Pour garantir une bonne étanchéité à la périphérie du plateau distributeur, il est recommandé de prévoir, entre l'anneau de support et le bord arrondi des plaques périphériques, un joint d'étanchéité du type décrit ci-dessus.

Comme indiqué plus haut, chaque plaque perforée rectangulaire comporte deux bords opposés, conformés en partie mâle ou en partie femelle. Une plaque perforée formant élément du plateau distributeur selon l'invention peut comporter, soit deux bords mâles, soit deux bords femelles, soit un bord mâle et un bord femelle.

Dans un premier mode de réalisation du plateau distributeur de la présente invention, une rangée de plaques rectangulaires perforées est constituée de plaques identiques comportant chacune un bord plié en forme de partie mâle et un bord plié en forme de partie femelle. Dans ce mode de réalisation, le bord femelle de chaque plaque est bloqué par le bord mâle de la plaque voisine venant s'emboîter par le haut dans le bord femelle.

Il est par conséquent nécessaire, pour enlever une des plaques en milieu de rangée, par exemple en vue de dégager un espace pour constituer un trou d'homme dans le plateau distributeur, de débloquer son bord femelle en soulevant au préalable le bord mâle de la plaque adjacente. Cette opération pourrait s'avérer difficile pour une seule personne.

Ce problème est résolu par un autre mode de réalisation du plateau distributeur de la présente invention, dans lequel une rangée de plaques rectangulaires perforées est constituée à la fois de plaques comportant deux bords pliés en forme de partie mâle et de plaques comportant deux bords pliés en forme de partie femelle, ces deux types de plaques étant disposés en alternance. Ce mode de réalisation présente l'avantage que n'importe laquelle des plaques à deux bords mâles peut être retirée sans qu'il soit nécessaire de soulever au préalable une plaque adjacente. Le problème ci-dessus n'est toutefois par résolu lorsqu'on souhaite retirer deux plaques adjacentes, car un des bords mâles de la deuxième plaque sera bloqué par le bord femelle de la troisième plaque.

Dans un troisième mode d'assemblage, particulièrement préféré, de la présente invention, il est possible de retirer un nombre souhaité de plaques dans une rangée sans qu'il soit nécessaire de soulever au préalable la plaque voisine. Dans ce mode de réalisation, une rangée de plaques rectangulaires perforées est constituée d'une plaque comportant deux bords pliés en forme de partie mâle et de plusieurs autres plaques, comportant chacune un bord plié en forme de partie mâle et un bord plié en forme de partie femelle, disposées de part et d'autre de celle-ci. L'assemblage d'une telle rangée se fait en partant des deux extrémités de la rangée par emboîtement du bord mâle de chaque nouvelle plaque dans le bord femelle d'une plaque déjà installée et se termine par la mise en place de la plaque comportant deux bords mâles. Lorsqu'il s'agit d'ouvrir un trou d'homme dans une telle rangée, on commencera par ôter la plaque à deux bords mâles, puis éventuellement un certain nombre de plaques voisines dont aucune ne sera bloquée par une plaque adjacente.

L'invention a pour objet non seulement un plateau tel que décrit ci-dessus mais également une enceinte comportant un tel plateau. Lorsqu'une, plusieurs ou la totalité des plaques formant le plateau comportent des perforations permettant le passage d'une phase fluide homogène ou hétérogène, le plateau joue le rôle de plateau distributeur. Une enceinte selon l'invention comportant un tel plateau distributeur est de préférence un réacteur, par exemple un réacteur chimique à lit de catalyseur fixe fonctionnant à co-courant gaz/liquide descendant. Dans un autre mode de réalisation, l'enceinte comportant un plateau distributeur selon l'invention est une colonne de distillation. Les perforations des plaques sont alors de préférence pourvues de clapets.

L'invention est maintenant décrite en référence aux dessins annexés, non limitatifs, dans lesquels :
- la figure 1 est une vue par le dessus d'un plateau distributeur selon l'invention,
- la figure 2 est une vue en perspective par le dessous de deux plaques assemblées par emboîtement du bord mâle dans le bord femelle,
- la figure 3 est une vue en coupe transversale d'une rangée de plaques assemblées selon un mode de réalisation préféré de l'invention,
- chacune des figures 4a, 4b, 4c et 4d est une vue en détail d'une jonction entre deux plaques du plateau, montrant différents modes de réalisation de joints,
- la figure 5 est une vue en perspective par le dessus d'une plaque perforée, fixée sur une poutre de support au moyen d'une clavette.

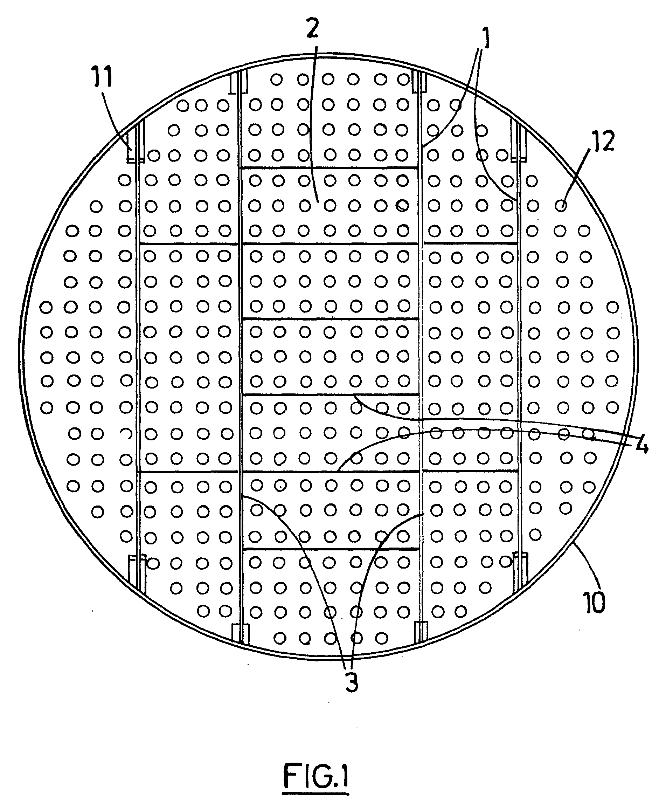

La figure 1 montre un plateau de distribution selon l'invention constitué de quatre poutres 1, parallèles les unes aux autres et situées dans un même plan, supportant plusieurs séries de plaques 2. Les poutres 1 sont fixées, au moyen de dispositifs de fixation 11 connus, sur un anneau de support (non visible) fixé à son tour à la paroi 10 du réacteur.

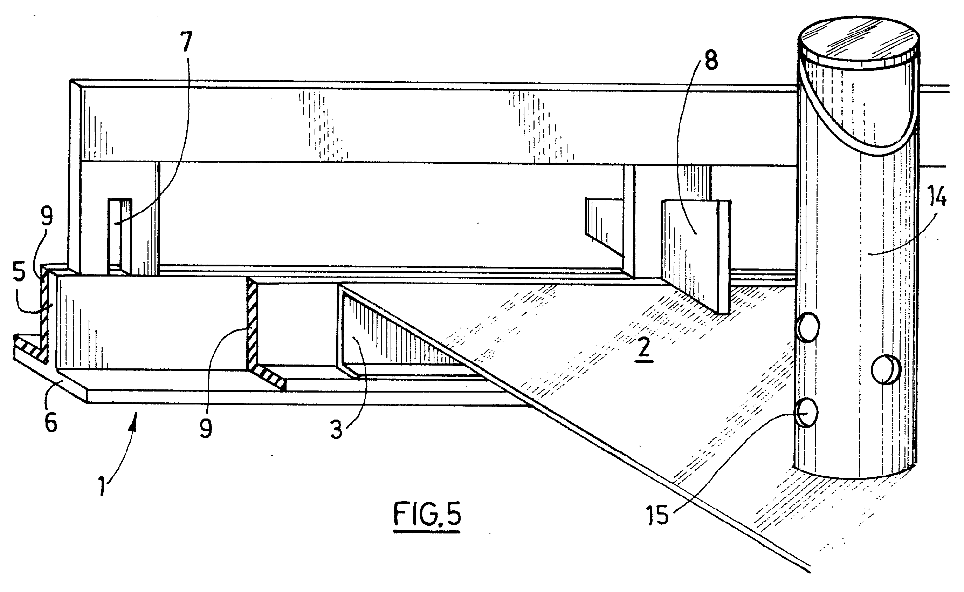

L'ensemble des plaques 2, à l'exception de celles en contact avec la paroi 10 du réacteur, ont une forme rectangulaire. Chaque plaque rectangulaire 2 a deux bords 3 par lesquels elle repose sur les poutres 1, et deux bords 4, perpendiculaires aux poutres 1 et aux bords 3, emboîtés les uns dans les autres de la manière expliquée plus en détail dans les figures suivantes. Chaque plaque, quelle soit rectangulaire ou non, comporte un certain nombre de perforations 12 disposées à une distance régulière les unes des autres. Ces perforations 12, destinées à mélanger la phase liquide et la phase gazeuse, introduites par le haut du réacteur, et à répartir le mélange gaz/liquide sur toute la surface du lit catalytique sous-jacent, sont généralement entourées d'une cheminée destinée à faire barrage au liquide, décrite plus en détail sur la figure 5 ci-après.

Les plaques perforées en contact avec la paroi 10 du réacteur cylindrique ont un bord arrondi qui épouse parfaitement la courbure de cette paroi 10. Les plaques rectangulaires 2 et non rectangulaires sont jointives et couvrent, en combinaison avec les poutres 1 sur lesquelles elles reposent, la totalité de la section transversale du réacteur, permettant ainsi une bonne rétention de la phase liquide qui s'écoulera uniquement par les perforations 12 prévues à cet effet.

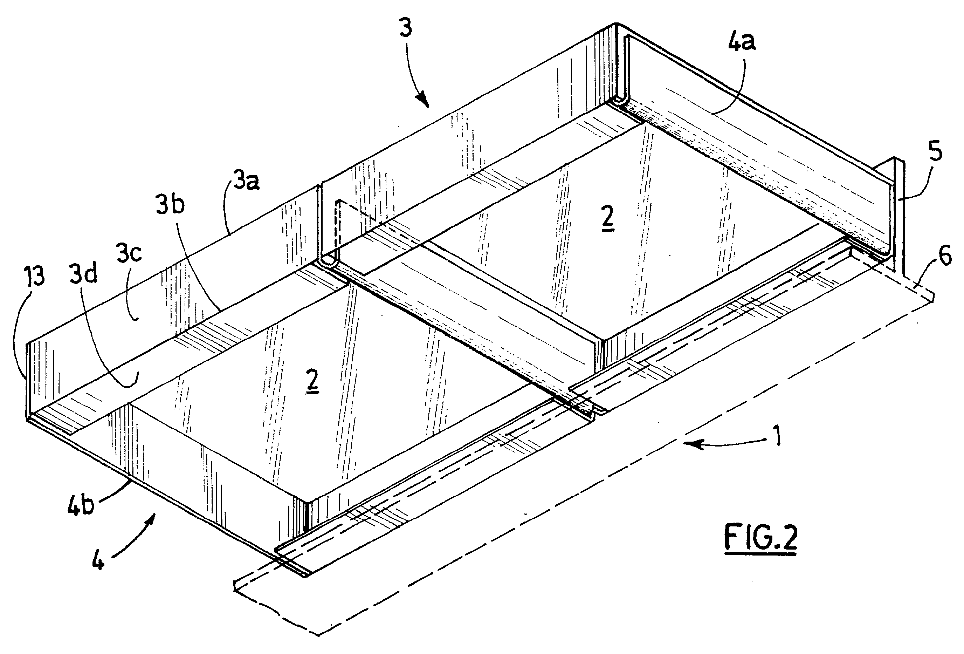

La figure 2 montre plus en détail la conformation particulière des bords pliés d'une plaque rectangulaire 2 formant un élément du plateau de distribution selon l'invention. Par souci de simplification du dessin, les plaques sont représentées sur cette figure sans les perforations 12 visibles sur la figure 1.

Chacune des plaques, en tôle métallique, comporte deux bords parallèles 3 par lesquels elle repose sur les poutres 1. Chaque bord 3 est formé par un double pli à angle droit s'étendant sur toute sa longueur, c'est-à-dire par un premier pli 3a à angle droit vers le bas définissant une partie verticale 3c, puis un deuxième pli 3b vers le centre de la plaque définissant une partie horizontale 3d, parallèle au plan principal de la plaque 2. Cette partie horizontale 3d repose sur une des deux branches horizontales 6 de la poutre 1, alors que la partie verticale 3c vient s'appliquer contre la branche verticale 5 de la poutre 1.

Chacune des plaques 2 a en outre deux bords d'assemblage 4, perpendiculaires aux bords 3. Ces bords d'assemblage sont conformés soit en bord femelle 4a, soit en bord mâle 4b. Un bord mâle 4b est formé par un simple pli à angle droit vers le bas. Un bord femelle 4a est formé par un pli à angle droit vers le bas, suivi d'un pli en arrondi vers le haut, définissant ainsi une structure en U étroit. Deux plaques 2 sont assemblées par simple insertion de la partie verticale d'un bord mâle 4b de l'une dans le U formé par le bord femelle 4a de l'autre.

Le mode de pliage particulier des bords décrits ci-dessus permet le soudage des bords 3 aux bords 4, le long de la ligne de jonction 13 aux coins des plaques, augmentant ainsi considérablement la rigidité de chaque plaque.

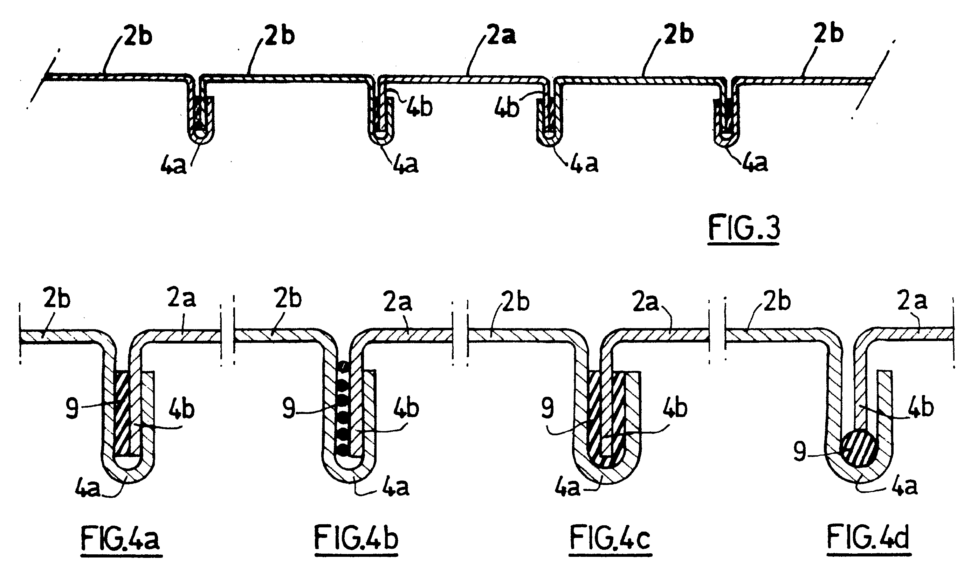

La figure 3 est une vue en coupe transversale d'une rangée de plaques assemblées selon un mode de réalisation préféré de la présente invention. Au centre de la rangée est disposée une plaque 2a comportant deux bords mâles 4b. Chacun de ces deux bords mâles 4b est inséré dans le bord femelle 4a d'une plaque voisine 2b « mixte », c'est-à-dire comportant un bord mâle 4b et un bord femelle 4a. Comme expliqué précédemment, ce mode d'assemblage des plaques permet le démontage facile et rapide de la rangée à partir du centre de celle-ci, c'est-à-dire à partir de la plaque 2a.

La figure 4a est une vue agrandie de la jonction d'assemblage de deux plaques de la rangée de plaques de la figure 3. Un joint d'étanchéité 9 en forme de bande, de préférence en fibres céramiques ou en fibres de carbone, est disposé entre la partie mâle 4b et la partie femelle 4a des plaques. Dans la figure 4b, le joint d'étanchéité 9 est constitué non pas d'une bande unique, comme dans la figure 4a, mais de plusieurs boudins parallèles. La figure 4c montre un joint d'étanchéité 9 sous forme d'une bande intercalée entre les parties mâle 4b et femelle 4a de la jonction et interdisant tout contact direct entre celles-ci. Selon encore un autre mode de réalisation, représenté à la figure 4d, le joint d'étanchéité 9 prend la forme d'un boudin à section circulaire situé au fond de la partie mâle 4b et sur lequel vient s'appuyer la partie femelle 4a de manière à interdire, comme dans la figure précédente, tout contact direct entre ces deux parties complémentaires.

Enfin, la figure 5 illustre un mode de fixation des plaques perforées rectangulaires 2 sur les poutres 1 du plateau distributeur de la présente invention.

Dans cette figure, la partie verticale 5 de la poutre 1 fait saillie au-delà du plan horizontal défini par les plaques 2. Dans cette partie faisant saillie sont prévus des orifices 7, ou guides, permettant d'insérer un moyen de fixation 8 connu, tel qu'une clavette. Cette clavette 8, grâce à son bord supérieur incliné, peut être forcée et bloquée à l'intérieur de l'orifice 7, par exemple à l'aide d'un marteau. Dans un mode de réalisation préféré, cette clavette 8 est formée de deux plaques soudées au niveau du bord vertical le plus long. L'écartement de ces deux plaques au niveau du « nez » (petite extrémité non soudée) de la clavette 8, après insertion de celle-ci dans le guide 7, assure un blocage efficace de la clavette 8 et de la plaque 2.

Un joint d'étanchéité 9 est intercalé entre le bord 3 de la plaque et la poutre 1. Ce joint d'étanchéité 9 est de préférence un tissé ou un tricot en fibres céramiques ou en fibres de carbone couvrant la totalité de la surface de contact entre ces deux éléments.

Cette figure montre également une cheminée 14 entourant une perforation 12 (non visible) dans la plaque 2. De manière connue, le gaz introduit par le haut du réacteur traverse cette cheminée 14 de haut en bas, entraînant sur son passage le liquide s'écoulant par les orifices 15 prévus au niveau de la base de la cheminée 14.

## Revendications

1. Plateau interne, disposé dans une enceinte, comprenant une pluralité de poutres (1) parallèles, situées dans un même plan horizontal et fixées par leurs extrémités à la paroi de l'enceinte, et, entre ces poutres et supportées par celles-ci, des rangées de plaques (2) rectangulaires jointives, couvrant complètement l'espace entre les poutres,
les bords d'appui (3) des plaques (2) par lesquels celles-ci reposent sur les poutres (1), étant pliés vers le bas par deux plis sensiblement à angle droit, **caractérisé par le fait**
**que** chacun des bords (4) des plaques (2), perpendiculaires aux poutres (1), est plié de manière à former une partie femelle (4a) ou une partie mâle (4b) capable de s'emboîter respectivement dans une partie mâle (4b) ou femelle (4a) formée par le bord plié de la plaque adjacente.

2. Plateau selon la revendication 1, **caractérisé par le fait que** chacune des plaques (2) comporte une pluralité de perforations, de préférence entourées chacune d'une paroi cylindrique verticale (cheminée) comprenant, à sa base, un ou plusieurs trous ou fentes.

3. Plateau selon la revendication 1 ou 2, **caractérisé par le fait que** les poutres (1) ont une section transversale comportant une partie en forme de T renversé avec une partie verticale (5) et deux parties horizontales (6) destinées à supporter les bords d'appui (3) des plaques rectangulaires formant le plateau.

4. Plateau selon la revendication 3, **caractérisé par le fait que** la partie verticale (5) des poutres (1) fait au moins en partie, saillie au-delà du plan horizontal défini par les plaques (2).

5. Plateau selon la revendication 4, **caractérisé par le fait que** les poutres (1) comportent, dans leur partie verticale (5) faisant saillie au-delà du plan horizontal défini par les plaques (2), des orifices (7) permettant d'insérer des moyens de fixation (8) pour immobiliser les plaques (2) sur les parties horizontales (6) des poutres.

6. Plateau selon la revendication 5, **caractérisé par le fait que** les moyens de fixation (8) sont des goupilles ou des clavettes.

7. Plateau selon l'une quelconque des revendications précédentes, **caractérisé par le fait qu'**une partie mâle (4b) est formée au niveau des bords (4) des plaques perforées (2) grâce à un simple pli dudit bord (4) vers le bas, de préférence un simple pli à angle droit vers le bas.

8. Plateau selon la revendication 7, **caractérisé par le fait qu'**une partie femelle (4a) est formée au niveau des bords (4) des plaques perforées (2) grâce à un pli vers le bas suivi d'un pli vers le haut, aboutissant à une conformation en V ou U.

9. Plateau selon l'une des revendications 7 et 8, **caractérisé par le fait que** les parties pliées des bords sont soudées les unes aux autres au niveau des coins des plaques perforées (2).

10. Plateau selon l'une quelconque des revendications précédentes, **caractérisé par le fait que** les plaques (2) sont fabriquées en un matériau rigide, tel un acier, de préférence inoxydable

11. Plateau selon l'une quelconque des revendications précédentes, **caractérisé par le fait que** les plaques ont une épaisseur comprise entre 1 mm et 10 mm, de préférence entre 3 mm et 5 mm.

12. Plateau selon l'une quelconque des revendications précédentes, **caractérisé par le fait que** des joints d'étanchéité (9) sont prévus au niveau des surfaces de contact entre la partie femelle (4a) d'une plaque et la partie mâle (4b) d'une plaque adjacente et/ou au niveau des surfaces de contact entre les poutres (1) et les parties pliées des bords (3) des plaques.

13. Plateau selon la revendication 12, **caractérisé par le fait que** le joint est en fibres céramiques ou en fibres de carbone.

14. Plateau selon l'une quelconque des revendications précédentes, **caractérisé par le fait qu'**une rangée de plaques (2) est constituée de plaques identiques comportant chacune un bord plié en forme de partie mâle (4b) et un bord plié en forme de partie femelle (4a).

15. Plateau selon l'une quelconque des revendication 1 à 13, **caractérisé par le fait qu'**une rangée de plaques (2) est constituée de plaques comportant deux bords pliés en forme de partie mâle (4b) et de plaques comportant deux bords pliés en forme de partie femelle (4a), disposées en alternance.

16. Plateau selon l'une quelconque des revendications 1 à 13, **caractérisé par le fait qu'**une rangée de plaques (2) est constituée d'une plaque comportant deux bords pliés en forme de partie mâle (4b) et de plusieurs autres plaques, comportant chacune un bord plié en forme de partie mâle (4b) et un bord plié en forme de partie femelle (4a), disposées de part et d'autre de celle-ci.

17. Enceinte comportant un plateau selon l'une quelconque des revendications précédentes.

18. Enceinte comportant un plateau selon l'une quelconque des revendications 2 à 16, **caractérisée par le fait qu'**il s'agit d'un réacteur, de préférence d'un réacteur chimique à lit de catalyseur fixe fonctionnant à co-courant gaz/liquide descendant.

19. Enceinte comportant un plateau selon l'une quelconque des revendications 2 à 16, **caractérisée par le fait qu'**il s'agit d'une colonne de distillation.

## Patentansprüche

1. Innenschale, die in einer Kammer angeordnet ist, die mehrere parallele Träger (1), die sich in einer gleichen horizontalen Ebene befinden und durch ihre Enden an der Wand der Kammer befestigt sind, und, zwischen diesen Trägern und durch sie gestützt, Reihen von aneinander stoßenden rechteckigen Platten (2) umfasst, die den Raum zwischen den Trägern vollständig abdecken,
wobei die Auflagekanten (3) der Platten (2), durch die diese auf den Trägern (1) aufliegen, durch zwei Falten im Wesentlichen rechtwinklig nach unten gefaltet sind, **dadurch gekennzeichnet, dass**
jede der Kanten (4) der Platten (2), die senkrecht zu den Trägern (1) sind, derart gefaltet ist, dass sie einen aufnehmenden Teil (4a) oder einen aufgenommenen Teil (4b) bildet, der in der Lage ist, in einen aufgenommenen (4b) beziehungsweise aufnehmenden Teil (4a) ineinanderzugreifen, der durch die gefaltete Kante der benachbarten Platte gebildet ist.

2. Schale nach Anspruch 1, **dadurch gekennzeichnet, dass** jede der Platten (2) mehrere Lochungen umfasst, die vorzugsweise jeweils durch eine vertikale zylindrische Wand (Schornstein) umgeben sind, die an ihrer Basis ein/en oder mehrere Löcher oder Schlitze umfasst.

3. Schale nach Anspruch 1 oder 2, **dadurch gekennzeichnet, dass** die Träger (1) einen Querschnitt aufweisen, der einen Teil mit der Form eines umgekehrten Ts mit einem vertikalen Teil (5) und zwei horizontalen Teilen (6) umfasst, die dazu bestimmt sind, die Auflagekanten (3) der rechteckigen Platten zu stützen, die die Schale bilden.

4. Schale nach Anspruch 3, **dadurch gekennzeichnet, dass** der vertikale Teil (5) der Träger (1) zumindest teilweise über die durch die Platten (2) definierte horizontale Ebene hinaus hervorragt.

5. Schale nach Anspruch 4, **dadurch gekennzeichnet, dass** die Träger (1) in ihrem vertikalen Teil (5), der über die durch die Platten (2) definierte horizontale Ebene hinaus hervorragt, Öffnungen (7) umfassen, die das Einsetzen von Befestigungsmitteln (8) zum Feststellen der Platten (2) auf den horizontalen Teilen (6) der Träger ermöglichen.

6. Schale nach Anspruch 5, **dadurch gekennzeichnet, dass** die Befestigungsmittel (8) Stifte oder Keile sind.

7. Schale nach einem der vorhergehenden Ansprüche, **dadurch gekennzeichnet, dass** ein aufgenommener Teil (4b) im Bereich der Kanten (4) der gelochten Platten (2) mittels einer einfachen Falte der Kante (4) nach unten, vorzugsweise einer einfachen Falte rechtwinklig nach unten, gebildet ist.

8. Schale nach Anspruch 7, **dadurch gekennzeichnet, dass** ein aufnehmender Teil (4a) im Bereich der Kanten (4) der gelochten Platten (2) mittels einer Falte nach unten, auf die eine Falte nach oben folgt, gebildet ist, die zu einer V- oder U-förmigen Gestaltung führen.

9. Schale nach einem der Ansprüche 7 und 8, **dadurch gekennzeichnet, dass** die gefalteten Teile der Kanten im Bereich der Ecken der gelochten Platten (2) aneinandergeschweißt sind.

10. Schale nach einem der vorhergehenden Ansprüche, **dadurch gekennzeichnet, dass** die Platten (2) aus einem starren Material, wie beispielsweise einem Stahl, vorzugsweise rostfrei, hergestellt sind.

11. Schale nach einem der vorhergehenden Ansprüche, **dadurch gekennzeichnet, dass** die Platten eine Dicke aufweisen, die zwischen 1 mm und 10 mm, vorzugsweise zwischen 3 mm und 5 mm, umfasst ist.

12. Schale nach einem der vorhergehenden Ansprüche, **dadurch gekennzeichnet, dass** Dichtungen (9) im Bereich der Kontaktflächen zwischen dem aufnehmenden Teil (4a) einer Platte und dem aufgenommenen Teil (4b) einer benachbarten Platte und/oder im Bereich der Kontaktflächen zwischen den Trägern (1) und den gefalteten Teilen der Kanten (3) der Platten vorgesehen sind.

13. Schale nach Anspruch 12, **dadurch gekennzeichnet, dass** die Dichtung aus Keramikfasern oder aus Kohlenstofffasern hergestellt ist.

14. Schale nach einem der vorhergehenden Ansprüche, **dadurch gekennzeichnet, dass** eine Reihe von Platten (2) aus identischen Platten besteht, die jeweils eine gefaltete Kante mit der Form eines aufgenommenen Teils (4b) und eine gefaltete Kante mit der Form eines aufnehmenden Teils (4a) umfassen.

15. Schale nach einem der Ansprüche 1 bis 13, **dadurch gekennzeichnet, dass** eine Reihe von Platten (2) aus Platten besteht, die zwei gefaltete Kanten mit der Form eines aufgenommenen Teils (4b) umfassen, und aus Platten, die zwei gefaltete Kanten mit der Form eines aufnehmenden Teils (4a) umfassen, die abwechselnd angeordnet sind.

16. Schale nach einem der Ansprüche 1 bis 13, **dadurch gekennzeichnet, dass** eine Reihe von Platten (2) aus einer Platte besteht, die zwei gefaltete Kanten mit der Form eines aufgenommenen Teils (4b) umfasst, und aus mehreren anderen Platten, die jeweils eine gefaltete Kante mit der Form eines aufgenommenen Teils (4b) und eine gefaltete Kante mit der Form eines aufnehmenden Teils (4a) umfassen, die auf beiden Seiten davon angeordnet sind.

17. Kammer, die eine Schale nach einem der vorhergehenden Ansprüche umfasst.

18. Kammer, die eine Platte nach einem der Ansprüche 2 bis 16 umfasst, **dadurch gekennzeichnet, dass** es sich um einen Reaktor, vorzugsweise um einen Chemiereaktor mit festem Katalysatorbett handelt, der mit einem Gas-/Flüssigkeits-Abwärtsgleichstrom arbeitet.

19. Kammer, die eine Schale nach einem der Ansprüche 2 bis 16 umfasst, **dadurch gekennzeichnet, dass** es sich um eine Destillationskolonne handelt.

## Claims

1. Inner tray, placed in a chamber, comprising a plurality of parallel beams (1), located in a common horizontal plane and fixed via their ends to the chamber wall, and, between said beams and supported thereby, rows of adjacent rectangular plates (2), completely covering the space between the beams,
the supporting edges (3) of the plates (2) through which said plates rest on the beams (1), being folded downward by two substantially right-angle folds, **characterized in that**
each of the edges (4) of the plates (2), perpendicular to the beams (1), is folded so as to form a female part (4a) or a male part (4b) capable of nesting respectively in a male part (4b) or a female part (4a) formed by the folded edge of the adjacent plate.

2. Tray according to claim 1, **characterized in that** each of the plates (2) comprises a plurality of perforations, preferably each surrounded by a vertical cylindrical wall (riser) comprising, at its base, one or more holes or slits.

3. Tray according to claim 1 or 2, **characterized in that** the beams (1) have a cross section comprising an inverted T-shaped part with a vertical part (5) and two horizontal parts (6) for supporting the supporting edges (3) of the rectangular plates forming the tray.

4. Tray according to claim 3, **characterized in that** the vertical part (5) of the beams (1) projects at least partly beyond the horizontal plane defined by the plates (2).

5. Tray according to claim 4, **characterized in that** the beams (1) comprise, in their vertical part (5) projecting beyond the horizontal plane defined by the plates (2), orifices (7) for inserting fixing means (8) to immobilize the plates (2) on the horizontal parts (6) of the beams.

6. Tray according to claim 5, **characterized in that** the fixing means (8) are pins or keys.

7. Tray according to any one of the preceding claims, **characterized in that** a male part (4b) is formed at the edges (4) of the perforated plates (2) via a single downward fold of said edge (4), preferably a single downward right-angle fold.

8. Tray according to claim 7, **characterized in that** a female part (4a) is formed at the edges (4) of the perforated plates (2) via a downward fold followed by an upward fold, culminating in a V or U conformation.

9. Tray according to either claim 7 or 8, **characterized in that** the folded parts of the edges are welded to one another at the corners of the perforated plates (2).

10. Tray according to any one of the preceding claims, **characterized in that** the plates (2) are made from a rigid material, such as a steel, preferably stainless.

11. Tray according to any one of the preceding claims, **characterized in that** the plates have a thickness of between 1 mm and 10 mm, preferably between 3 mm and 5 mm.

12. Tray according to any one of the preceding claims, **characterized in that** seals (9) are provided at the contact surfaces between the female part (4a) of one plate and the male part (4b) of an adjacent plate and/or at the contact surfaces between the beams (1) and the folded parts of the edges (3) of the plates.

13. Tray according to claim 12, **characterized in that** the seal is made from ceramic fibers or carbon fibers.

14. Tray according to any one of the preceding claims, **characterized in that** a row of plates (2) consists of identical plates each comprising a folded edge shaped like a male part (4b) and a folded edge shaped like a female part (4a).

15. Tray according to any one of claims 1 to 13, **characterized in that** a row of plates (2) consists of plates comprising two folded edges shaped like a male part (4b) and plates comprising two folded edges in the shape of a female part (4a), arranged alternately.

16. Tray according to any one of claims 1 to 13, **characterized in that** a row of plates (2) consists of a plate comprising two folded edges shaped like a male part (4b) and several other plates, each comprising a folded edge in the shape of a male part (4b) and a folded edge in the shape of a female part (4a), placed on either side thereof.

17. Chamber comprising a tray according to any one of the preceding claims.

18. Chamber comprising a tray according to any one of claims 2 to 16, **characterized in that** it is a reactor, preferably a chemical reactor having a fixed catalyst bed operating with gas/liquid cocurrent downflow.

19. Chamber comprising a tray according to any one of claims 2 to 16, **characterized in that** it is a distillation column.
